# EUROPEAN PATENT APPLICATION

(11) **EP 1 956 666 A1**
(43) Date of publication of application: **13.08.2008**
(21) Application number: 06833362.4
(22) Date of filing: 27.11.2006
(51) Int. Cl.: H01L 51/50, C09K 11/06

(54) **ORGANIC ELECTROLUMINESCENT DEVICE**

(30) Priority: 01.12.2005 JP 2005347991
(71) Applicant: Nippon Steel Chemical Co., Ltd., Chiyoda-ku Tokyo 101-0021 (JP)
(72) Inventor: ASARI, Tohru, Kitakyushu-shi, Fukuoka 804-8503 (JP); YAMAMOTO, Toshihiro, Kitakyushu-shi, Fukuoka 804-8503 (JP); KOMORI, Masaki, Kitakyushu-shi, Fukuoka 804-8503 (JP); KAI, Takahiro, Kitakyushu-shi, Fukuoka 804-8503 (JP)
(74) Representative: Whalley, Kevin
(86) International application number: PCT/JP2006/323558
(87) International publication number: WO 2007/063796

(57) **Abstract**

Disclosed is an organic electroluminescent device (organic EL device) which is improved in luminous efficiency, fully assured of driving stability, and simple in constitution. The organic electroluminescent device comprises a hole-transporting layer, a light-emitting layer, and an electron-transporting layer disposed between an anode and a cathode piled one upon another on a substrate and the light-emitting layer contains a phosphorescent dopant and an indolocarbazole compound of specific structure. Examples of the indolocarbazole compound are N,N' -diphenylindolocarbazole and bis(N-phenylindolo)carbazole.

## Description

### Technical Field

This invention relates to an organic electroluminescent device (hereinafter referred to as organic EL device) and, more particularly, to an organic EL device that emits light of high luminance by simultaneous use of a phosphorescent dopant and a host compound of specific structure.

### Background Technology

An organic EL device of the simplest structure is generally constituted of a light-emitting layer sandwiched between a pair of counter electrodes and utilizes the following light-emitting phenomenon. Upon application of voltage to the electrodes, electrons are injected from a cathode and holes are injected from an anode and they recombine in the light-emitting layer; after recombination, the energy level in the conduction band goes back to the energy level in the valence band with release of energy in the form of light.

In recent years, organic thin films have been used in the development of EL devices. In particular, devices that comprise a hole-transporting layer of an aromatic diamine and a light-emitting layer of 8-hydroxyquinoline aluminum complex (hereinafter referred to as Alq3) disposed in thin film between the electrodes have been developed following the optimization of the kind of electrodes for the purpose of improving the efficiency of carrier injection from the electrodes and enhancing the luminous efficiency. The devices of this kind have produced remarkable improvement in luminous efficiency over the conventional devices utilizing single crystals of anthracene and the like and the developmental works of organic EL devices thereafter have aimed at commercial application to high-performance flat panels featuring self luminescence and high-speed response.

The utilization of phosphorescence in place of fluorescence is experimented to enhance the luminous efficiency of the device. The aforementioned devices comprising a hole-transporting layer of an aromatic diamine and a light-emitting layer of Alq3 and many others utilize fluorescence. Now, the utilization of phosphorescence, that is, emission of light from the triplet excited state, is expected to enhance the luminous efficiency approximately three times that of the conventional devices utilizing fluorescence (singlet). To achieve this object, studies were conducted on the use of coumarin derivatives and benzophenone derivatives in the light-emitting layer, but the result was nothing but extremely low luminance. Thereafter, europium complexes were tried in the utilization of the triplet excited state, but they failed to emit light at high efficiency.

Patent document 1: JP2003-515897 A
Patent document 2: JP2001-313178 A
Patent document 3: JP2002-305083 A
Patent document 4: JP2002-352957 A
Patent document 5: JP11-162650 A
Patent document 6: JP11-176578 A

A large number of phosphorescent dopants useful for the light-emitting layer of an organic EL device are disclosed in JP2003-515897 A and elsewhere. A typical example is tris(2-phenylpyridine)iridium complex (hereinafter referred to as Ir(ppy)3).

It is a carbazole compound or CBP cited in JP2001-313178 A that is proposed as a host material for use in the light-emitting layer of an organic EL device. However, the use of CBP as a host material for Ir(ppy)3 that is a phosphorescent material emitting green light destroys the balanced injection of electrical charges as CBP has a property of facilitating the flow of holes and obstructing the flow of electrons and excess holes flow out to the side of the electron-transporting layer to lower the luminous efficiency from Ir(ppy)3.

As a means to solve the aforementioned problem, a hole-blocking layer may be disposed between the light-emitting layer and the electron-transporting layer. The hole-blocking layer can accumulate holes efficiently in the light-emitting layer thereby improving the probability of recombination of holes and electrons in the light-emitting layer and enhancing the luminous efficiency. The hole-blocking materials in general use include 2,9-dimethyl-4,7-diphenyl-1,10-phenanthroline (hereinafter referred to as BCP) and p-phenylphenolato-bis(2-methyl-8-quinolinolato-N1,08)aluminum (hereinafter referred to as BAlq). A hole-blocking material such as this can prevent electrons and holes from recombining in the electron-transporting layer. However, BCP lacks reliability as a hole-blocking material as it tends to crystallize easily at room temperature and a device comprising BCP shows an extremely short operating life. On the other hand, BAlq has a Tg of approximately 100°C and a device comprising BAlq is reported to show a relatively long operating life, but the hole-blocking ability of BAlq is not sufficient and the luminous efficiency from Ir(ppy)3 drops. An additional problem arises in that an increase of one layer complicates the layered structure of the device and increases the cost.

On the other hand, 3-phenyl-4-(1'-naphthyl)-5-phenyl-1,2,4-triazole (hereinafter referred to as TAZ) is also proposed as a host material for a phosphorescent organic EL device as cited in JP2002-352957 A; however, TAZ has a property of facilitating the flow of electrons and obstructing the flow of holes and the light-emitting range is displaced toward the side of the hole-transporting layer. Hence, it is conceivable that the luminous efficiency from Ir(ppy)3 may drop depending upon the compatibility of the material used in the hole-transporting layer with Ir(ppy)3, For example, 4,4' -bis[N-(1-naphthyl)-N-phenylamino]biphenyl (hereinafter referred to as NPB) that is used most widely as a hole-transporting material for its excellent performance, high reliability, and long operating life shows poor compatibility with Ir(ppy)3 and problems arise in that energy transition occurs from Ir(ppy)3 to NPB and the luminous efficiency drops.

The indolocarbazole compounds disclosed in JP11-162650 A and JP11-176578 A are recommended for use as a hole-transporting material and their stability is highly regarded, but these documents do not teach the use as a phosphorescent host material.

### Disclosure of the Invention

### Problems to be Solved by the Invention

In applications of organic EL devices to display devices such as flat panel displays, it is necessary to improve the luminous efficiency of the device and, at the same time, to fully secure the driving stability of the device. Under the aforementioned circumstances, an object of this invention is to provide an organic EL device that performs at high efficiency with good driving stability and is suitable for practical use.

### Means to Solve the Problems

The inventors of this invention have conducted intensive studies, found that the use of a compound having a specific indolocarbazole skeleton as a phosphorescent host material can solve the aforementioned problem, and completed this invention.

The organic electroluminescent device of this invention comprises a light-emitting layer disposed between an anode and a cathode piled one upon another on a substrate and the light-emitting layer contains a phosphorescent dopant and a compound represented by the following general formula (1) as a host material.

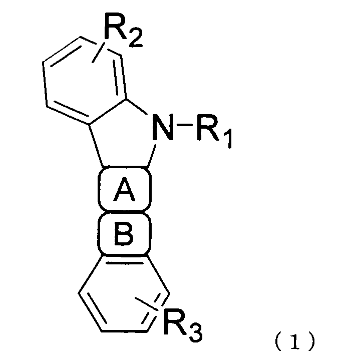

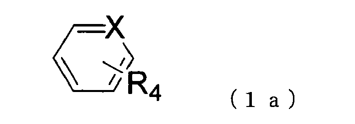

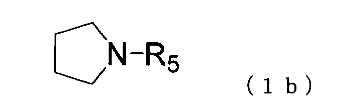

wherein,
ring A is an aromatic or heterocyclic ring condensed with the adjacent rings and represented by formula (1a),
ring B is a heterocyclic ring condensed with the adjacent rings and represented by formula (1 b),
X is carbon or nitrogen,
each of R₁ and R₅ is a non-condensed substituted or unsubstituted aromatic hydrocarbon group or a non-condensed substituted or unsubstituted aromatic heterocyclic group,
R₄ is hydrogen, a non-condensed substituted or unsubstituted aromatic hydrocarbon group, a non-condensed substituted or unsubstituted aromatic heterocyclic group, or a ring condensed with the X-containing ring, and
each of R₂ and R₃ is hydrogen, an alkyl group, an aralkyl group, an alkenyl group, an alkynyl group, a cyano group, a dialkylamino group, a diarylamino group, a diaralkylamino group, an amino group, a nitro group, an acyl group, an alkoxycarbonyl group, a carboxyl group, an alkoxyl group, an alkylsulfonyl group, a haloalkyl group, a hydroxyl group, an amide group, a substituted or unsubstituted aromatic hydrocarbon group, or a substituted or unsubstituted aromatic heterocyclic group.

The compounds represented by general formula (1) comprise compounds represented by the following general formula (2) or (3). 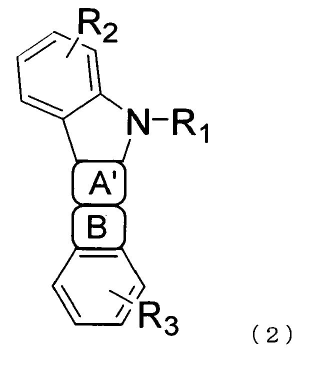 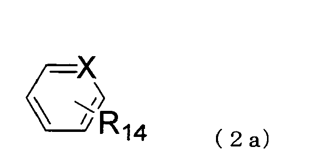 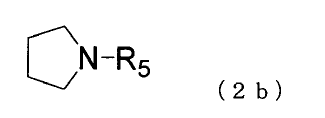 wherein,
ring A' is an aromatic or heterocyclic ring condensed with the adjacent rings and represented by formula (2a),
ring B is a heterocyclic ring condensed with the adjacent rings and represented by formula (2b),
R₁₄ is hydrogen, a non-condensed substituted or unsubstituted aromatic hydrocarbon group, or a non-condensed substituted or unsubstituted aromatic heterocyclic group, and
X, R₁ to R₃, and R₅ are as defined above.

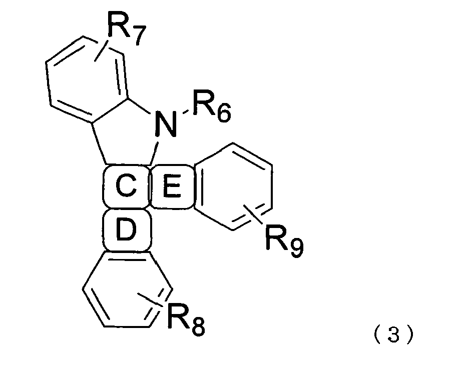

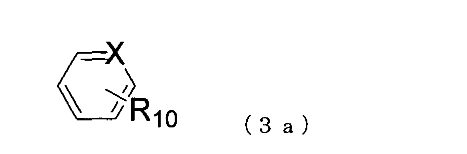

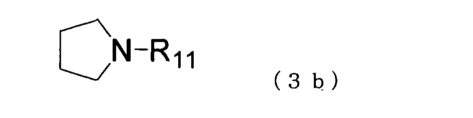

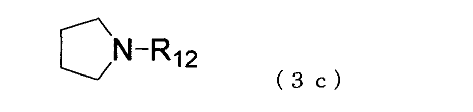

wherein,
ring C is an aromatic or heterocyclic ring condensed with the adjacent rings and represented by formula (3a),
ring D is a heterocyclic ring condensed with the adjacent rings and represented by formula (3b),
ring E is a heterocyclic ring condensed with the adjacent rings and represented by formula (3c), X is carbon or nitrogen,
each of R₆, R₁₁, and R₁₂ independently has the same meaning as R₁,
R₁₀ has the same meaning as R₁₄, and
each of R₇ to R₉ independently has the same meaning as R₂.

The compounds represented by general formula (2) or (3) wherein ring A' or ring C is a benzene ring, each of R₁, R₅, R₆, R₁₁, and R₁₂ is a substituted or unsubstituted phenyl or pyridyl group, and each of R₂, R₃, R₇, R₈, and R₉ is hydrogen or a phenyl group provide excellent organic electroluminescent devices.

The organic electroluminescent device of this invention preferably has a hole-injecting/transporting layer disposed between the anode and the light-emitting layer and an electron-injecting/transporting layer disposed between the cathode and the light-emitting layer. Further, the device preferably has a hole-blocking layer disposed between the light-emitting layer and the electron-injecting/transporting layer.

In this invention, a compound represented by the aforementioned general formula (1) is used as a phosphorescent host material. Of the compounds represented by general formula (1), the compounds represented by general formula (2) or (3) are preferred. In general formula (1), ring A is an aromatic or heterocyclic ring condensed with the adjacent rings and represented by formula (1a) and ring B is a heterocyclic ring condensed with the adjacent rings and represented by general formula (1b). In general formula (2), ring A' is an aromatic or heterocyclic ring condensed with the adjacent rings and represented by formula (2a) and ring B is a heterocyclic ring condensed with the adjacent rings and represented by formula (2b). In general formula (3), ring C is an aromatic or heterocyclic ring condensed with the adjacent rings and represented by formula (3a), ring D is a heterocyclic ring condensed with the adjacent rings and represented by formula (3b), and ring E is a heterocyclic ring condensed with the adjacent rings and represented by formula (3c). In formulas (1a), (2a), and (3a), X is carbon or nitrogen, preferably carbon.

In these formulas, each of R₁, R₅, R₆, R₁₁, and R₁₂ is independently a non-condensed substituted or unsubstituted aromatic hydrocarbon group or a non-condensed substituted or unsubstituted aromatic heterocyclic group. Examples of the aromatic hydrocarbon group include a phenyl group and a biphenylyl group. Each of R₁₀ and R₁₄ may be independently a non-condensed substituted or unsubstituted aromatic hydrocarbon group or a non-condensed substituted or unsubstituted aromatic heterocyclic group and, in addition, each of R₁₀ and R₁₄ may be independently hydrogen. The group R₄ is a non-condensed substituted or unsubstituted aromatic hydrocarbon group, a non-condensed substituted or unsubstituted aromatic heterocyclic group, or hydrogen and, in addition, R₄ may be a ring condensed with the X-containing six-membered ring in formulas (1a), (2a), and (3a). When R₄ is a ring, it may be a condensed ring. An example of the case in point is ring E having a condensed ring represented by general formula (3). Here, the ring is preferably an indole ring which may have R₉. In this case, a nitrogen-containing ring is condensed with the X-containing six-membered ring.

Each of R₂, R₃, R₇, R₈, and R₉ is independently hydrogen, an alkyl group, an aralkyl group, an alkenyl group, an alkynyl group, a cyano group, a dialkylamino group, a diarylamino group, a diaralkylamino group, an amino group, a nitro group, an acyl group, an alkoxycarbonyl group, a carboxyl group, an alkoxyl group, an alkylsulfonyl group, a haloalkyl group, a hydroxyl group, an amide group, a substituted or unsubstituted aromatic hydrocarbon group, or a substituted or unsubstituted aromatic heterocyclic group. In the case where these groups have aliphatic hydrocarbon chains, the number of carbon atoms in the chains is preferably in the range of 1 to 4. In the case where the groups have aromatic groups or both aromatic groups and aliphatic hydrocarbon chains, the number of carbon atoms is preferably in the range of 5 to 12.

A compound represented by general formula (1), (2), or (3) for use in this invention can be prepared easily by a known method. For example, a compound represented by general formula (2) can be prepared by the following reactions with reference to the synthetic example shown in Synlett, 2005, No. 1, pp. 42-48.

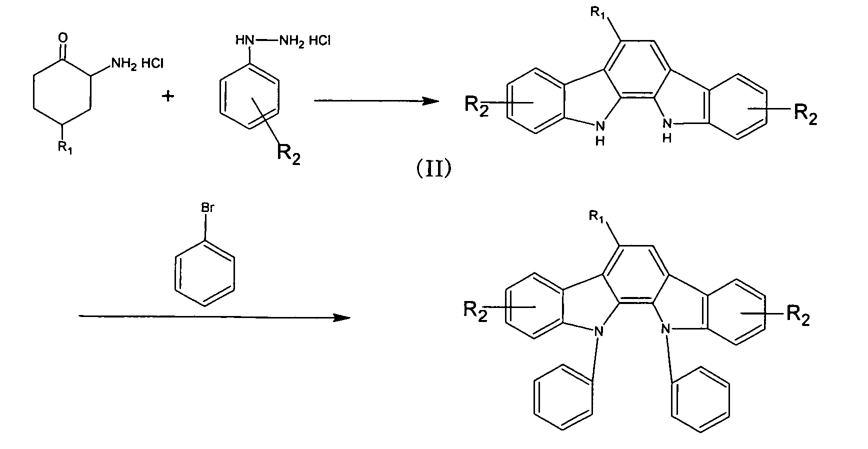

Preferable examples of the compounds represented by general formula (1), (2), and (3) are shown below, but useful compounds are not limited thereto. The number assigned to the chemical formula is the compound number.

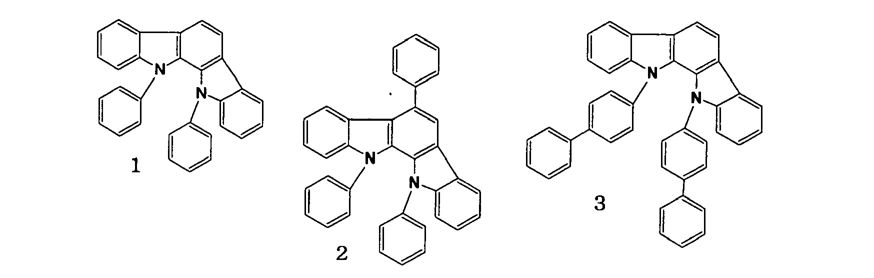

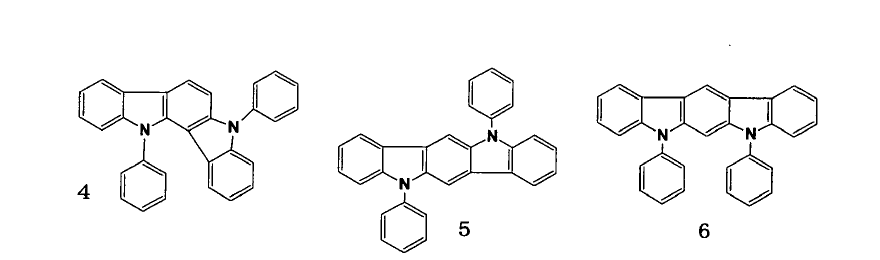

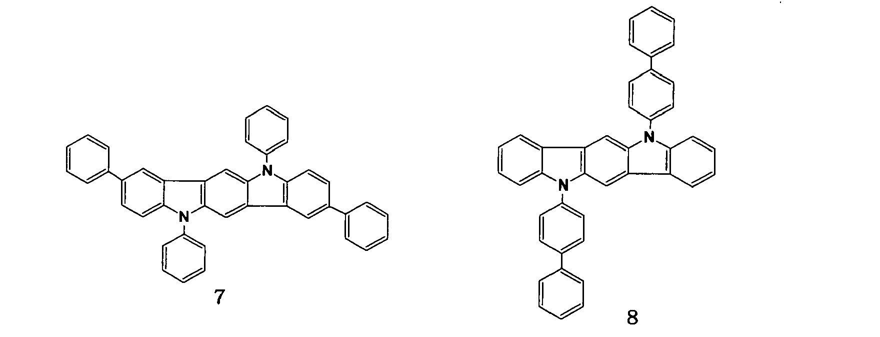

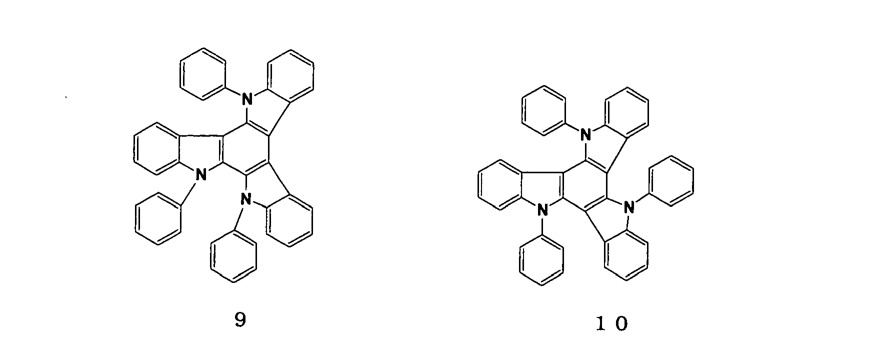

The phosphorescent dopants in the light-emitting layer are preferably organic metal complexes comprising at least one metal selected from ruthenium, rhodium, palladium, silver, rhenium, osmium, iridium, platinum, and gold. These organic metal complexes are known in the aforementioned patent documents and elsewhere and a suitable complex is selected from them and used.

Examples of preferable phosphorescent dopants include complexes containing a noble metal such as Ir in the center, typically Ir(ppy)3, complexes such as Ir(bt)2 - acac3, and complexes such as PtOEt3. Concrete examples of these complexes are shown below, but the complexes useful for this invention are not limited thereto.

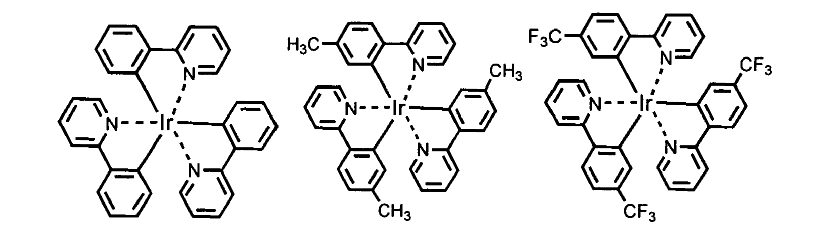

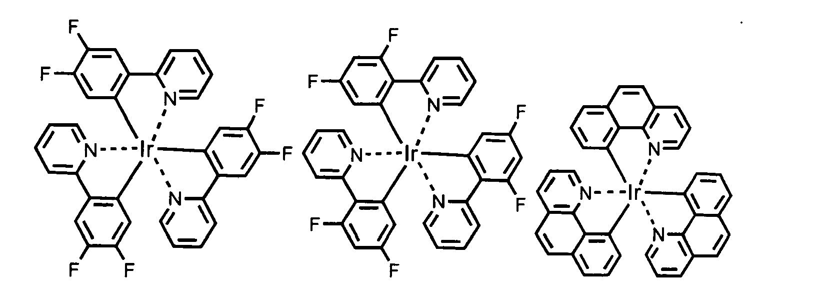

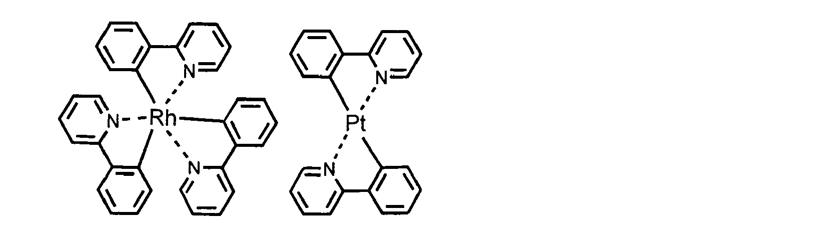

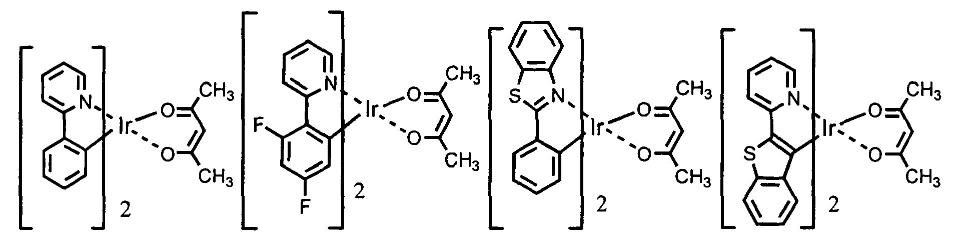

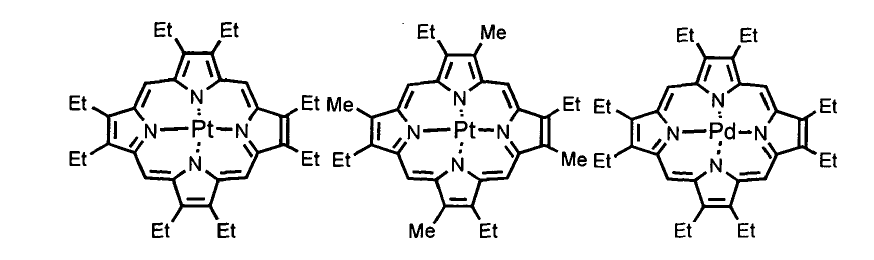

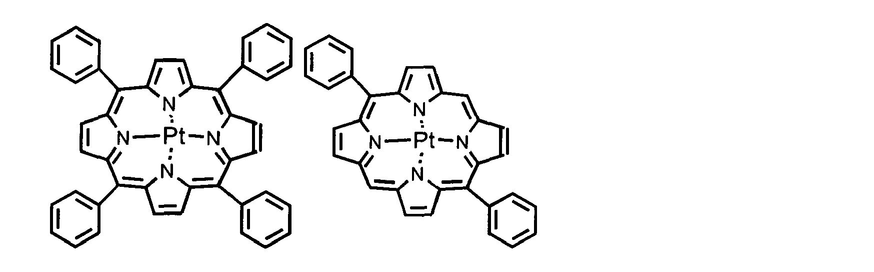

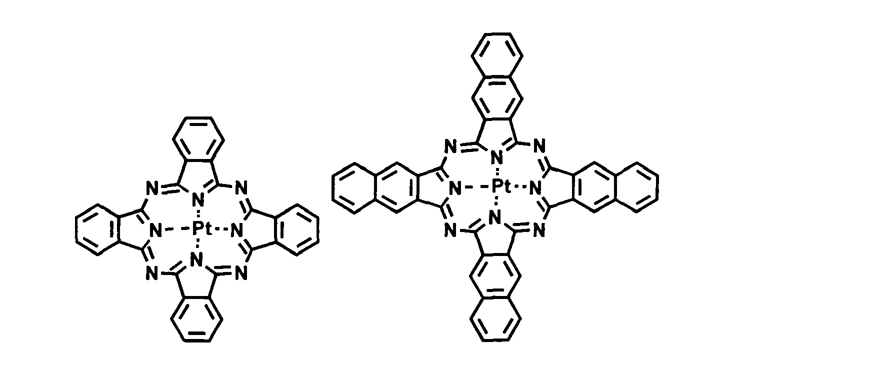

The content of any of the aforementioned phosphorescent dopants in the light-emitting layer is preferably in the range of 5 to 10 wt%.

### Brief Description of the Drawing

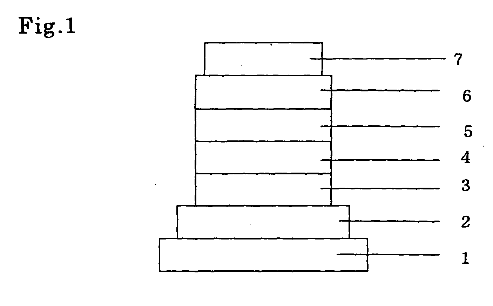

[Fig. 1] A schematic drawing of an organic EL device.

### Explanation of Symbols

1 Substrate, 2 Anode, 3 Hole-injecting layer, 4 Hole-transporting layer, 5 Light-emitting layer, 6 Electron-transporting layer, 7 Cathode.

### Preferred Embodiments of the Invention

The organic EL device of this invention comprising a compound represented by the aforementioned general formula (1) as a phosphorescent host material will be described below.

The organic EL device of this invention is an organic EL device comprising at least one light-emitting layer disposed between an anode and a cathode piled one upon another on a substrate and the light-emitting layer contains a phosphorescent dopant and a compound represented by general formula (1), preferably by general formula (2) or (3), as a host material.

The structure of the organic EL device of this invention will be described below with reference to the drawing, but it is not limited to the one illustrated by the drawing.

Fig. 1 schematically shows the cross section of an example of organic EL device generally used in this invention. In Fig. 1, the number designates the following; 1 a substrate, 2 an anode, 3 a hole-injecting layer, 4 a hole-transporting layer, 5 a light-emitting layer, 6 an electron-transporting layer, and 7 a cathode. The organic EL device of this invention comprises the substrate, the anode, the light-emitting layer, and the cathode as essential layers, but it preferably contains, in addition to the other non-essential layers, a hole-injecting/transporting layer and an electron-injecting/transporting layer and further a hole-blocking layer disposed between the light-emitting layer and the electron-injecting/transporting layer. The hole-injecting/transporting layer means one or both of the hole-injecting layer and the hole-transporting layer and the electron-injecting/transporting layer means one or both of the electron-injecting layer and the electron-transporting layer.

It is possible to construct a device having a structure that is the reverse of the structure shown in Fig. 1, that is, the cathode 7, the electron-transporting layer 6, the light-emitting layer 5, the hole-transporting layer 4, and the anode 2 can be piled one upon another in this order on the substrate 1. As described earlier, it is also possible to dispose the organic EL device of this invention between two substrates at least one of which is highly transparent. In this case, it is also possible to add or omit a layer or layers if necessary.

The organic EL device of this invention is applicable to a single device, a device with its structure arranged in array, or a device in which the anode and the cathode are arranged in X-Y matrix. The organic EL device of this invention produces remarkable improvement in luminous efficiency and driving stability over the conventional devices utilizing emission of light from the singlet state by incorporating a compound of specific skeleton and a phosphorescent dopant in its light-emitting layer and it can perform excellently when applied to full-color or multicolor panels.

### Examples

This invention will be described in more detail below with reference to the examples, but it will not be limited thereto.

### Example 1

Compound 1 was deposited on a glass substrate from an evaporation source at a rate of 1.0Å/sec to a thickness of 50 nm by the vacuum deposition process at a degree of vacuum of 4.0 x 10⁻⁴ Pa. The thin film thus formed was evaluated by a fluorometer.
Separately, compound 1 and Ir(ppy)3 were codeposited on a glass substrate from different evaporation sources at a rate of 1.0Å/sec to a thickness of 50 nm by the vacuum deposition process at a degree of vacuum of 4.0 x 10⁻⁴ Pa while controlling the concentration of Ir(ppy)3 at 7.0%.
The thin film thus formed was evaluated by a fluorometer. The maximum absorption wavelength of compound 1 was used as the excitation wavelength and the light then emitted was observed and compared with the light emitted from the film of compound 1 alone. The results are shown in Table 1.

### Example 2

A thin film was formed as in Example 1 with the exception of using compound 5 in place of compound 1. The results are shown in Table 1.

### Comparative Example 1

A thin film was formed as in Example 1 with the exception of using Alq3 in place of compound 1. The results are shown in Table 1.

**[Table 1]**

| | Emission of light from host | Emission of light from dopant |
|---|---|---|
| Example1 | × | ○ |
| Example2 | × | ○ |
| Comparative example1 | ○ | × |

It is apparent that energy transition occurs to Ir(ppy)3 and light emits from Ir(ppy)3 when compound 1 or compound 5 is used as a host material in the light-emitting layer, but energy transition does not occur to Ir(ppy)3 and Alq3 itself emits light when Alq3 is used.

### Example 3

An organic EL device was constructed as in Fig. 1 with omission of a hole-injecting layer and addition of an electron-injecting layer. Constituent layers were piled one upon another in thin film on a glass substrate on which a 150 nm-thick ITO anode had been formed by the vacuum deposition process at a degree of vacuum of 4.0 x 10⁻⁴ Pa. First, NPB was deposited on the ITO anode to a thickness of 60 nm to form a hole-transporting layer.
Next, compound 1 and Ir(ppy)₃ were codeposited from different evaporation sources on the hole-transporting layer to a thickness of 25 nm to form a light-emitting layer. The concentration of Ir(ppy)₃ at this time was 7.0%. Then, Alq3 was deposited to a thickness of 50 nm to form an electron-transporting layer. Further, lithium fluoride (LiF) was deposited to a thickness of 0.5 nm to form an electron-injecting layer. Finally, aluminum (Al) as an electrode was deposited on the electron-injecting layer to a thickness of 170 nm to complete an organic EL device.

The organic EL device thus obtained was connected to an outside power source and, upon application of direct current voltage, emission of light with the characteristics shown in Table 2 was confirmed. In Table 2, the luminance, voltage, and luminous efficiency are measured at 10 mA/cm². The maximum wavelength of the spectrum of light emitted from the device is 517 nm and this proves that Ir(ppy)₃ emits light.

### Comparative Example 2

An organic EL device was constructed as in Example 3 with the exception of using HMTPD in the hole-transporting layer and TAZ as the main component of the light-emitting layer.

### Comparative Example 3

An organic EL device was constructed as in Example 3 with the exception of using TAZ as the main component of the light-emitting layer.
The results are shown in Table 2.

**[Table 2]**

| | Luminance (cd/m²) | Voltage (V) | Luminous efficiency (1m/W) |
|---|---|---|---|
| example3 | 2387 | 7.8 | 9.6 |
| Comparative example2 | 2050 | 13.2 | 4.9 |
| Comparative example3 | 1270 | 9.5 | 4.2 |

### Industrial Applicability

The organic EL device of this invention can emit light of high luminance at high efficiency with application of low voltage. Hence, the organic EL device of this invention is applicable to flat panel displays (for example, office computers and wall-hanging television sets), vehicle display devices, cellular phone displays, light sources utilizing the characteristics of planar light emitters (for example, light sources of copiers and backlight sources of liquid crystal displays and instruments), signboards, and beacon lights and has a high technical value.

## Claims

1. An organic electroluminescent device comprising a light-emitting layer disposed between an anode and a cathode piled one upon another on a substrate wherein the light-emitting layer contains a phosphorescent dopant and a compound represented by the following general formula (1) as a host material: 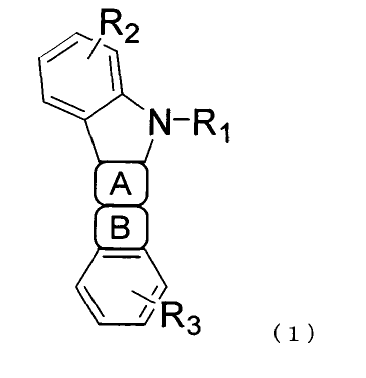 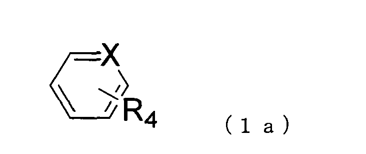 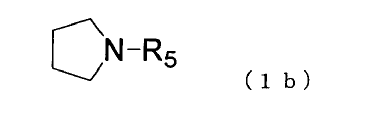 wherein, ring A is an aromatic or heterocyclic ring condensed with the adjacent rings and represented by formula (1a), ring B is a heterocyclic ring condensed with the adjacent rings and represented by formula (1b), X is carbon or nitrogen, each of R₁ and R₅ is a non-condensed substituted or unsubstituted aromatic hydrocarbon group or a non-condensed substituted or unsubstituted aromatic heterocyclic group, R₄ is hydrogen, a non-condensed substituted or unsubstituted aromatic hydrocarbon group, a non-condensed substituted or unsubstituted aromatic heterocyclic group, or a ring condensed with the X-containing ring, and each of R₂ and R₃ is hydrogen, an alkyl group, an aralkyl group, an alkenyl group, an alkynyl group, a cyano group, a dialkylamino group, a diarylamino group, a diaralkylamino group, an amino group, a nitro group, an acyl group, an alkoxycarbonyl group, a carboxyl group, an alkoxyl group, an alkylsulfonyl group, a haloalkyl group, a hydroxyl group, an amide group, a substituted or unsubstituted aromatic hydrocarbon group, or a substituted or unsubstituted aromatic heterocyclic group.

2. An organic electroluminescent device as described in claim 1 wherein the light-emitting layer contains a phosphorescent dopant and a compound represented by the following general formula (2) or (3) as a host material: 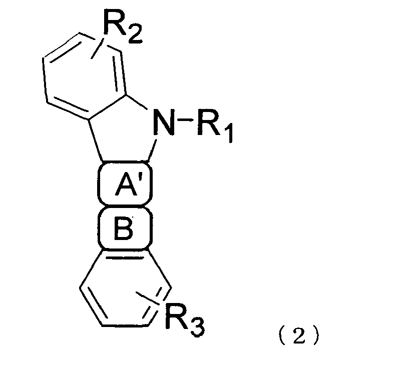 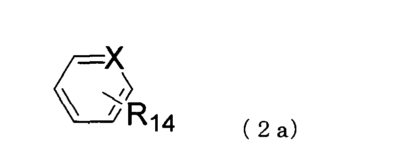 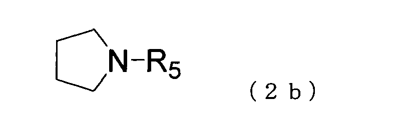 wherein, ring A' is an aromatic or heterocyclic ring condensed with the adjacent rings and represented by formula (2a), ring B is a heterocyclic ring condensed with the adjacent rings and represented by formula (2b), X is carbon or nitrogen, each of R₁ and R₅ is a non-condensed substituted or unsubstituted aromatic hydrocarbon group or a non-condensed substituted or unsubstituted aromatic heterocyclic group, R₁₄ is hydrogen, a non-condensed substituted or unsubstituted aromatic hydrocarbon group, or a non-condensed substituted or unsubstituted aromatic heterocyclic group, and each of R₂ and R₃ is hydrogen, an alkyl group, an aralkyl group, an alkenyl group, an alkynyl group, a cyano group, a dialkylamino group, a diarylamino group, a diaralkylamino group, an amino group, a nitro group, an acyl group, an alkoxycarbonyl group, a carboxyl group, an alkoxyl group, an alkylsulfonyl group, a haloalkyl group, a hydroxyl group, an amide group, a substituted or unsubstituted aromatic hydrocarbon group, or a substituted or unsubstituted aromatic heterocyclic group; 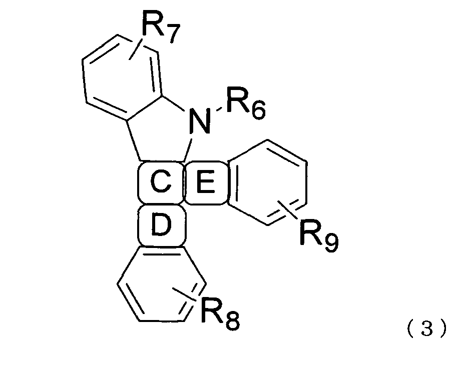 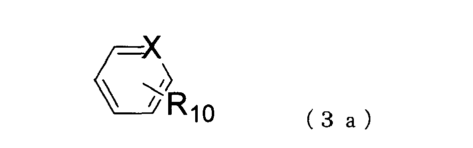 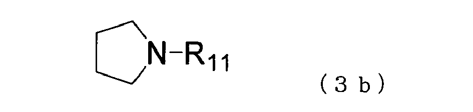 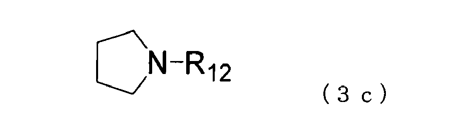 wherein, in general formula (3), ring C is an aromatic or heterocyclic ring condensed with the adjacent rings and represented by formula (3a), ring D is a heterocyclic ring condensed with the adjacent rings and represented by formula (3b), ring E is a heterocyclic ring condensed with the adjacent rings and represented by formula (3c), X is carbon or nitrogen, each of R₆, R₁₁, and R₁₂ independently has the same meaning as R₁, R₁₀ has the same meaning as R₁₄, and each of R₇, R₈, and R₉ independently has the same meaning as R₂.

3. An organic electroluminescent device as described in claim 2 wherein ring A' or ring C is a benzene ring, each of R₁, R₅, R₆, R₁₁, and R₁₂ is a substituted or unsubstituted phenyl or pyridyl group, and each of R₂, R₃, R₇, R₈, and R₉ is hydrogen or a phenyl group in general formula (2) or (3).

4. An organic electroluminescent device as described in claim 1 or 2 wherein a hole-injecting/transporting layer is disposed between the anode and the light-emitting layer and an electron-injecting/transporting layer is disposed between the cathode and the light-emitting layer.

5. An organic electroluminescent device as described in claim 3 wherein a hole-blocking layer is disposed between the light-emitting layer and the electron-injecting/transporting layer.
